# EUROPEAN PATENT APPLICATION

(11) **EP 3 540 601 A2**
(43) Date of publication of application: **18.09.2019**
(21) Application number: 19162356.0
(22) Date of filing: 12.03.2019
(51) Int. Cl.: G06F 11/07, G06F 13/42

(54) **DETECTION OF WIRING FAULTS IN SERIAL BUS CONNECTED COMPONENTS**

(30) Priority: 13.03.2018 IN 201811009166
(71) Applicant: Carrier Corporation, Jupiter, FL 33478 (US)
(72) Inventor: BHUYAN, Satyajit, 500081 Telangana (IN)
(74) Representative: Dehns

(57) **Abstract**

A system and method (400) for detecting a failure of a serial data bus (60). The system includes a serial data bus (60) and a controller (40), the controller (40) operably connected to the serial data bus (60) and configured to execute a process for detecting the failure. The process including transmitting a first selected data, on the data bus (410), reading the data on the data bus within a first selected time duration of having transmitted the first selected data (420), comparing the read data with the first selected data transmitted (430), and identifying a fault in the data bus if the read data does not match the first selected data (440). The system also includes a receiver, the receiver operably connected to the data bus and configured to receive data on the data bus transmitted by the controller.

## Description

### BACKGROUND

Exemplary embodiments pertain to the wiring and detection of faults in the wiring of serially communicating controllers and more particularly to building management systems and environmental control systems with serially communicating controllers.

A building management system can be used to monitor and/or control a building. For example, the user (e.g., operator) of a building management system can check and/or set the state of a control component(s), equipment, device(s), network(s) area(s), and/or space(s) of the building using the building management system. For instance, if an occupant is too hot or too cold, a building manager can investigate with the building management system to determine the temperature in the particular building space, any exceedances from set points, malfunctioning equipment and the like. As another example, a building management system of a building may perform multiple tasks or functions including that related to security, safety, environmental control, and others. Environmental control systems such as heating, ventilation, and air conditioning (HVAC) systems maintain desirable function and standards of service by keeping the environment in a building within a defined comfort zone of occupants. To do so, sensors, controllers, dampers, variable air volume (VAV) controllers and the like are distributed throughout the building space to facilitate managing the environment. Many of these systems communicate with serial communication interfaces to facilitate installation, commissioning, operation and diagnosis or maintenance of the various components of the system. Such serial communication interfaces provide the means for easy communication for components, however during installation and maintenance, faults in the wiring of the serial communication interface may occur. Such faults can be difficult to detect, cause system malfunctions, or result in poor building management system or environmental control system performance. To that end, it is desirable to be able to quickly recognize, diagnose, and correct wiring faults in the serial communications interfaces.

### BRIEF DESCRIPTION

Described herein in an embodiment is a system and method for detecting a failure of a serial data bus. The system includes a serial data bus and a controller, the controller operably connected to the serial data bus and configured to execute a process for detecting the failure. The process including transmitting a first selected data bit, byte, word, on the data bus, reading the data on the data bus within a first selected time duration of having transmitted the first selected data, comparing the read data with the first selected data transmitted, and identifying a fault in the data bus if the read data does not match the first selected data. The system also includes a receiver, the receiver operably connected to the data bus and configured to receive data on the data bus transmitted by the controller.

In addition to one or more of the features described above, or as an alternative, further embodiments may include that the data bus is a three wire half duplex data bus.

In addition to one or more of the features described above, or as an alternative, further embodiments may include that the data is a bit.

In addition to one or more of the features described above, or as an alternative, further embodiments may include that the data bus is at least one of an ACTnet data bus, and an RS-485 data bus.

In addition to one or more of the features described above, or as an alternative, further embodiments may include that the first selected data includes at least one of a "1", and a "0".

In addition to one or more of the features described above, or as an alternative, further embodiments may include that the first selected time duration is based on a data rate of the data bus.

In addition to one or more of the features described above, or as an alternative, further embodiments may include that the first selected time duration is 8.33 milliseconds when the data rate of the data bus is 2400 baud.

In addition to one or more of the features described above, or as an alternative, further embodiments may include that the identifying a fault includes ascertaining that the data bus is shorted to the supply power if the read data is a "1" and the first selected data is not a "1".

In addition to one or more of the features described above, or as an alternative, further embodiments may include that the identifying a fault includes ascertaining that the data bus is shorted to ground if the read data is a "0" and the first selected data is not a "0".

In addition to one or more of the features described above, or as an alternative, further embodiments may include disabling the data bus if a fault is identified.

In addition to one or more of the features described above, or as an alternative, further embodiments may include that the data bus provides communication between a controller and a component of an environmental control system.

In addition to one or more of the features described above, or as an alternative, further embodiments may include that the component of the environmental control system includes at least one of a variable air flow valve, a damper, and a fan coil.

Also described herein in an embodiment is a system for detecting a failure of a serial data bus. The system includes a serial data bus, a controller, the controller operably connected to the serial data bus and configured to execute a process for detecting a failure in the serial data bus. The process includes transmitting a first selected data, on the data bus, reading data on the data bus within a first selected time duration of having transmitted the first selected data, comparing the read data with the first selected data transmitted, and identifying a fault in the data bus if the read data does not match the first selected data. The system also includes a receiver, the receiver operably connected to the data bus and configured to receive data on the data bus transmitted by the controller.

In addition to one or more of the features described above, or as an alternative, further embodiments may include that the data bus is a three wire half duplex data bus.

In addition to one or more of the features described above, or as an alternative, further embodiments may include that the data bus is at least one of an ACTnet data bus, and an RS-485 data bus.

In addition to one or more of the features described above, or as an alternative, further embodiments may include that the first selected data includes at least one of a "1" and a "0".

In addition to one or more of the features described above, or as an alternative, further embodiments may include that the first selected time duration is based on the data rate of the data bus.

In addition to one or more of the features described above, or as an alternative, further embodiments may include that the first selected time duration is 8.33 milliseconds when the data rate of the data bus is 2400 baud.

The system set forth in claim 12, wherein the identifying a fault includes ascertaining that the data bus is shorted to the supply power if the read data is a "1" and the first selected data is not a "1".

In addition to one or more of the features described above, or as an alternative, further embodiments may include that the identifying a fault includes ascertaining that the data bus is shorted to ground if the read data is a "0" and the first selected data is not a "0".

In addition to one or more of the features described above, or as an alternative, further embodiments may include disabling the data bus if a fault is identified.

In addition to one or more of the features described above, or as an alternative, further embodiments may include that the receiver comprises a component of an environmental control system.

In addition to one or more of the features described above, or as an alternative, further embodiments may include that the component of the environmental control system includes at least one of a variable air flow valve, a damper, and a fan coil.

Also disclosed herein is a building management system for controlling and monitoring systems in a building including an environmental control system, the building management system including environmental control hardware constructed and arranged to condition the environment, a serial data bus, and a controller. The controller operably connected to the serial data bus and configured to execute a process for fault detection in the serial data bus including transmitting a first selected data, on the data bus, reading data on the data bus within a first selected time duration of having transmitted the first selected data, comparing the read data with the first selected data transmitted, and identifying a fault in the data bus if the read data does not match the first selected data. The environmental control hardware also includes a receiver, the receiver operably connected to the data bus and configured to receive data on the data bus transmitted by the controller.

### BRIEF DESCRIPTION OF THE DRAWINGS

The foregoing and other features, and advantages of the present disclosure are apparent from the following detailed description taken in conjunction with the accompanying drawings in which:
FIG. 1 is a schematic of a building management system;
FIG. 2 depicts a simplified block diagram of a computing system as may be implemented in a controller or user device;
FIG. 3 depicts a simplified graphical depiction of a serial communication network and signal timing;
FIG. 4 is a flowchart of a method detecting a wiring error in a serial communication bus.

### DETAILED DESCRIPTION

Embodiments herein are directed to a building management system and or environmental control system employing serial communications interfaces. In particular a method and system for detecting faults in a conventional three wire serial communication bus. The system includes a three wire serial data bus that generally operates half duplex connected to a controller. The controller executes a methodology that includes transmitting a first selected data, on the data bus and then reading the data on the data bus within a first selected time duration of having transmitted the first selected data. The method also includes comparing the read data with the first selected data that was transmitted. In addition that method also includes identifying a fault in the data bus if the read data does not match the first selected data. Otherwise the controller considers the communication bus as operating normally and continues use. The system also includes a receiver of the data for example an actuator, the receiver operably connected to the data bus and configured to receive data on the data bus transmitted by the controller.

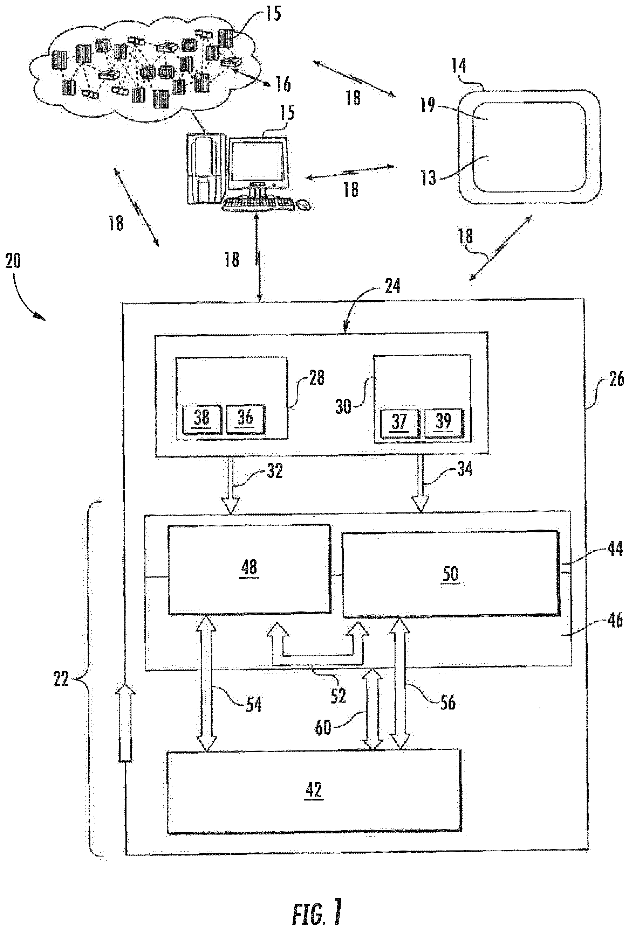

Referring to FIG. 1, a building management system 20 may be constructed and arranged to handle a host of building functions and/or attributes including that related to environmental control, security, safety, fire protection, occupancy detection or monitoring, various combination thereof, and other functions. Environmental control may be handled, at least in-part, by an environmental control system 22 that may expend energy to control factors such as heating, cooling, humidity, lighting and other factors. Other aspects of the building management system 20 may include an occupancy and environment monitoring system 24 that may be configured to at least monitor the number of occupants (e.g., people, livestock, pets, etc.) entering and/or leaving a campus, building, room, building space, region, and the like 26. The occupancy and environment monitoring system 24 may be part of any variety of subsystems of the building management system 20 including, for example, part of an access control security system. Alternatively, the occupancy and environment monitoring system 24 may be a dedicated part of the environmental control system 22. It is further contemplated and understood that the region 26 may be an entire building, a floor of the building, and/or specific areas of the building or floor. Moreover, a building management system 20 could also provide services for and manage multiple buildings 26, for example a campus.

The occupancy and environment monitoring system 24 may include an event module 28 for monitoring and tracking ingress and egress activity in the building space 26. The ingress and egress event module 28 is configured to respectively send ingress and egress data (as depicted by arrow 32) to the environmental control system 22, and in particular controller 40. Together, the ingress and egress data 32 may be termed 'occupancy data.' The ingress and egress modules 28 may include respective ingress and egress sensing devices 36, 38. In one embodiment, one or both of the sensing devices 36, 38 may be, for example, security card or badge readers configured to read and identify security cards (or badges) worn by occupants entering and exiting the building 26. In another embodiment, the sensing device 36 and/or the sensing device 38 may be an electrical contact mounted to a door, and configured to send a door actuation signal indicative of one or more occupants leaving the building 26. It is further contemplated and understood that the sensing devices 36, 38 may be associated with any technology that applies an 'access granted' method including biometric scanners and mobile device commands.

The environment monitoring system 24 may also include a sensing module 30 for monitoring and tracking environmental settings and conditions associated with the building space 26. The environment sensing module 30 is configured to send environmental sensor and status data (as depicted by arrow 34) may be termed "environment data" the environmental control system 22, and in particular controller 40. The sensing modules 30 may include various respective environment sensing and operational devices 37, 39. In one embodiment, one or both of the sensing devices 37, 39 may be, for example, thermostats, controllers, temperature sensors, humidity sensors, and/or C02 sensors throughout the building 26. In another embodiment, the sensing devices 37 and/or the sensing device 39 may also include or be part of a mobile device or user device 14 for interfacing with the environment control system 22. It is further contemplated and understood that the sensing devices 37, 39 may be associated with any technology that applies an environment sensing and/or control method including biometric scanners and mobile device commands.

The modules 28, 30 may further include a controller, or a common controller (not shown), as part of the environment monitoring system 24 that may be, or may be part of, a security system or environmental control system e.g. 22. The controller(s) may be configured to receive the signals outputted by the sensing devices 36, 38, 37, 39, among others, process the signals, and output the occupancy data 32, and/or environmental data 34 to the environmental control system 22. In another embodiment, the controller(s) 40 may process the signals from sensors such as the sensing devices 36, 38, 37, 39 and output a signal indicative of combined occupancy data 32 and environmental data 34.

The environmental control system 22 may include one or more controller(s) 40 and environmental control hardware 42 that may generally be started, monitored, stopped, and otherwise controlled by the controller 40. The environmental control hardware 42 may include hardware components, known to one having skill in the art, for the heating, cooling, control of humidity, lighting, and/or control of other factors pertaining to the environment. The controller 40 may be an integral part of a controller of the building management system 20, or may be a dedicated controller of the environmental control system 22 or other systems like a security system or access control system, and the like. The controller 40 may also be part of a server denoted generally as 15 and/or the user device 14 that is employed to interface with other components of the building management system 20 and execute processes for building management, environmental control, diagnostics, and the like in accordance with the embodiments described herein. In addition, some, or all of the functionality provided may be based on methods and processes executed locally or remotely such as on a local or remote server 15 and/or cloud computing environment 16. As will be appreciated the cloud computing environment 16 could include a local or remote server 15, or the server 16 and cloud computing environment 16 could be entirely remote. As used herein, the processing of the embodiments described herein may be executed in the controller 40 or server 15 or other servers all to be referred to herein generally as controller 40. The controller 40 may include a processor 44 (e.g., microprocessor), a computer writeable and readable storage medium 46, memory, displays, and the like as described in further detail herein. The controller 40 may be configured to receive the occupancy data 32 and environmental data 34 from the environment monitoring system 24. The controller 40 may also be configured to receive data from various other sensors associated with the environmental control system 22 and the building management system 20. For example, building state, time, date, operational information and commands, and the like. Likewise, the controller 40 may be configured to receive data from the various components of the environmental conditions hardware 42, including but not limited to states of fans, pumps, valves, dampers and the like all depicted generally as 54, 56.

The building management system 20 may further include the user device 14 that is employed to facilitate interfaces with the system 20 as will be described at a later point herein. The user device 14 is configured to interface with the controller 40, server 15, and/or the cloud computing environment 16 in order to facilitate operation of and interfaces with the building management system 20. In some embodiments, the user device 14 may incorporate some or all of the functions of the controller 40. In addition, the building management system 20 may also include a local and remote communication network and system, shown generally as 18 for facilitating communication and control of various features in the system 20 as well as for facilitating communication between a user device 14, controller 40, server 15, and the cloud computing environment 16, other components and sensors in the system 20, and the like.

Likewise, the system 20 may also include one or more application(s) (app) 19 operable on the user device 14, controller 40, and/or the server 15 that permits and facilitates the user to enter and receive information and for user device 14 to communicate with, interface with, and control selected aspects of system 20. The app 19 and the user device 14 may include a user interface 13 to enable the user to interface with the user device 14 and the app 19 being executed thereon. In an embodiment, the app 19 may be employed by the user, for example, to facilitate use of diagnostic applications for evaluating the status of one or more communication networks 18 associated with the building system 20. The app 19 may also facilitate establishing user preferences associated with the system 20 and methods described herein.

Controller 40 may include one or more functions, modules, or applications 48, 50 for controlling various aspects of the building management system 20. More specifically, the modules 48, 50 may, at least in-part, be software-based or computer programs including a variety of user defined settings, preferences, thresholds and may further include a variety of operational commands that may be stored in the storage medium 46 and executed by the processor 44 of the controller 40. In one embodiment, the modules 48, 50 may be programmed to receive the respective occupancy data 32, or environmental data 34 associated with the building 26. In an embodiment, the data 32, 34 may be received at intervals or continuously (i.e., 24 hours a day, 7 days a week). The modules 48, 50 and thus the controller 40 may generally communicate with one-another (see arrow 52 in FIG. 1) to generally share data, information, status and the like. In addition, the modules 48, 50 and thus the controller 40 also communicates with the environmental control hardware 42 as depicted by arrows 54, 56 respectively.

Server 15 may be part of a cloud computing environment 16. Cloud computing is a widely adopted and evolving concept. Generally, cloud computing refers to a model for enabling ubiquitous, convenient, and on-demand access via Internet to shared pools of configurable computing resources such as networks, servers, storages, applications, functionalities, and the like. There are a number of benefits associated with cloud computing for both the providers of the computing resources and their customers. For example, customers may develop and deploy various business applications on a cloud infrastructure supplied by a cloud provider without the cost and complexity to procure and manage the hardware and software necessary to execute the applications. The customers do not need to manage or control the underlying cloud infrastructure, e.g., including network, servers, operating systems, storage, etc., but still have control over the deployed applications. On the other hand, the provider's computing resources are available to provide multiple customers with different physical and virtual resources dynamically assigned and reassigned according to clients' load. Further, cloud resources and applications are accessible via the Internet.

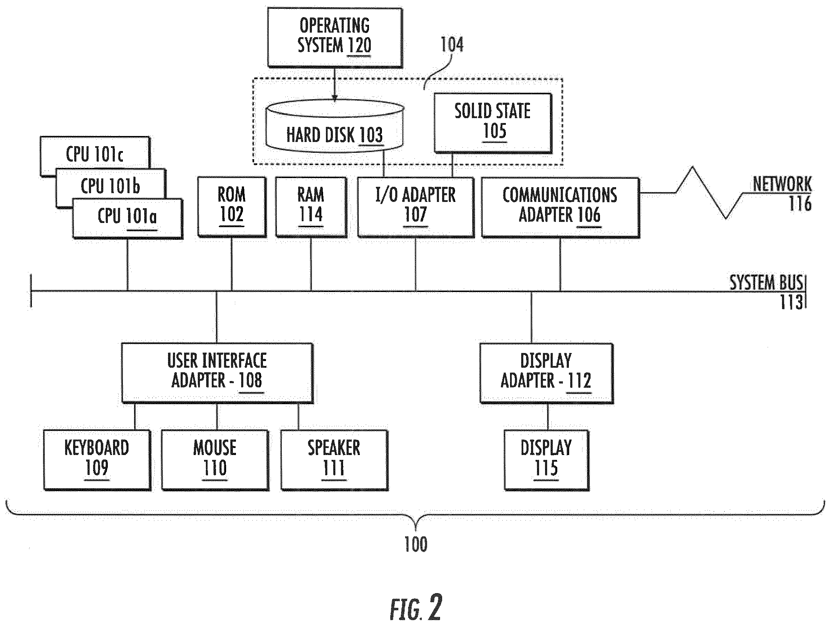

Cloud computing environment 16 includes one or more cloud computing nodes, such as processing or communication nodes, such as servers like server 15 with which computing devices such as, user devices 14 and controllers 40 may communicate. Cloud computing nodes e.g., server 15 may communicate with one another and/or be grouped (not shown) physically or virtually, in one or more networks. It is understood that the types of user/computing devices 14 shown in FIG. 2 are intended to be illustrative only and that computing nodes and cloud computing environment 16 can communicate with any type of computerized device over any type of network and/or network addressable connection (e.g., using a web browser).

The computing devices, e.g., 14, including controller 40, server 15, and user device 14 may be any form of a mobile device (e.g., smart phone, smart watch, wearable technology, laptop, tablet, etc.). The user device 14 can include several types of devices, in one instance, even a fixed device, e.g. a keypad/touch screen affixed to a wall in a building corridor/lobby, such as building system controllers. In other words, the server 15 and the user device 14 can all be computing devices 14. It should be appreciated that the servers 15 are typically part of the installed building system infrastructure, while commonly, the user device 14, as a mobile device/phone may typically be owned and used by the user, service man, homeowner, and the like. The term "user device" 14 is used to denote all of these types of devices as may be employed by the user for the purposes of communication with the building system 20. It should be appreciated that in some instances a user device 14 or the server 15 are proximate to the system(s) 20, for example, a particular locale, in others they are mobile for example, a car, PDA, or movable kiosk. For example, in an embodiment, the computing devices/user devices 14 could be, a personal digital assistant (PDA) or cellular telephone tablet, desktop computer /terminal/server, laptop computer, a tablet or kiosk, or a control panel of some sort for a building system 20, and the like. Computing devices/user devices 14 may also be configured to communicate with each other or a variety of sensors e.g., 36, 37, 38, 39 directly or via communication network 18.

The user device 14, server 15, and controller 40 may communicate over one or more communication networks 18, (e.g., a communication bus) that may be wired or wireless. Wired communication could be serial communication buses, whether half or full duplex such as RS-485, ActNet, BACnet, and the like. Other wired communication could be standard Ethernet such as IEEE 802.11. In an embodiment, a half-duplex serial communication network such as ActNet or RS-485 is employed. Wireless communication networks can include, but are not limited to, Wi-Fi, short-range radio (e.g., Bluetooth®), near-field (NFC), infrared, cellular network, etc. In some embodiments, user device 14 (e.g., computing device 14 may include, or be associated with (e.g., communicatively coupled to) one or more other networked building elements (not shown), such as computers, beacons, other system controllers, bridges, routers, network nodes, etc. The networked elements may also communicate directly or indirectly with the user devices 14 using one or more communication protocols or standards (e.g., through the network 18). For example, the networked element may communicate with the user device 14 using near-field communications (NFC) and thus enable communication between the user device 14 and any other components in the system 20 when in close proximity to the user device 14 (NFC is a short range wireless protocol). Or, for example, the networked element may communicate with the user device 14 using Bluetooth and thus communicate a unique ID and enable communication between the user device 14 and building system control unit 40 or any other components in the system 20 from a further distance. The network 18 may be any type of known communication network including, but not limited to, a wide area network (WAN), a local area network (LAN), a global network (e.g. Internet), a virtual private network (VPN), a cloud network, and an intranet. The network 18 may be implemented using a wireless network or any kind of physical network implementation known in the art. The user devices 14 and/or the computing devices may be coupled to the server 15, through multiple networks (e.g., cellular and Internet) so that not all user devices 14 and/or the computing devices are coupled to the any given server 15 or component through the same network 18. One or more of the user devices 14 and servers 15 may be connected in a wireless fashion. In one non-limiting embodiment, the network 18 is the Internet and one or more of the user devices 14 executes a user interface application (e.g. a web browser, mobile app 19) to contact and communicate through the network 18.

Referring to FIG. 2, the computing device 14, server 15, and controllers 40, may include a processing/computing system 100 including a processor, memory, and communication module(s), as needed to perform the functions of described herein in accordance with the various embodiments. In one embodiment, the computing devices 14, and servers 15, controller 40 each may include a computing system 100 having a computer program stored on nonvolatile memory to execute instructions via a microprocessor related to aspects of building management and control and the data visualization of the embodiments described herein.

In an embodiment, the computing system 100 has one or more processing units (processors) 101a, 101b, 101c, etc. (collectively or generically referred to as processor(s) 101). The processor(s) 101 can be any type or combination of computer processors, such as a microprocessor, microcontroller, digital signal processor, application specific integrated circuit, programmable logic device, and/or field programmable gate array. As is conventionally done, the processors 101 are coupled to system memory 114 and various other components via a system bus 113. The memory can be a non-transitory computer readable storage medium tangibly embodied including executable instructions stored therein, for instance, as firmware. Read only memory (ROM) 102 is coupled to the system bus 113 and may include a basic operating system, which controls certain basic functions of system 100. Random Access Memory (RAM) 114 is also coupled to the system bus 113 and may include a basic storage space to facilitate program execution.

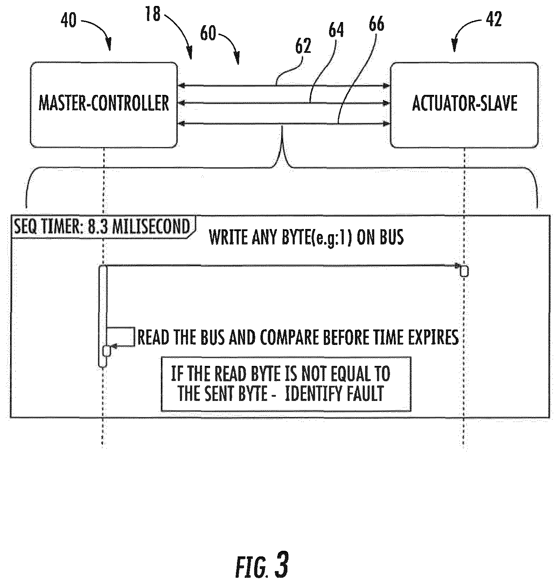

FIG. 2 further depicts an input/output (I/O) adapter 107 and a network communications adapter 106 coupled to the system bus 113. I/O adapter 107 communicates with hard disk 103 and/or solid state storage 105 or any other similar component. I/O adapter 107, hard disk 103, and solid state storage 105 are collectively referred to herein as mass storage 104. As is conventionally done an operating system 120 for execution on the processing system 100 may be stored in mass storage 104. A network adapter 106 interconnects bus 113 with an outside network 116 such as and including communications network 18 and the like, enabling computing system 100 to communicate with other such systems. The network adapter 106 may implement one or more communication protocols as described in further detail herein, and may include features to enable wired or wireless communication with external and/or remote devices separate from the user device 14. The computing device 14 including the server 15 and controller 40 may further include a user interface, shown generally as 13, e.g., a display screen, a microphone, speakers, input elements such as a keyboard 109 or touch screen, etc.as shown in FIG. 3) as known in the art. A screen (e.g., a display monitor) 115 is connected to system bus 113 by display adaptor 112, which may include a graphics adapter and a video controller. A keyboard 109, mouse 110, and speaker 111 all interconnected to bus 113 via user interface adapter 108. It should be appreciated that in some embodiments some or all of these elements of the computing system 100 may be integrated. In one embodiment, adapters 107, 106, and 112 may be connected to one or more I/O busses that are connected to system bus 113 via an intermediate bus bridge (not shown). Suitable I/O buses for connecting peripheral devices may also be employed. Additional input/output devices are shown as connected to system bus 113 via user interface adapter 108 and display adapter 112. It should be appreciated that the components of the system as described are for illustration purposes only. Features and functions as described may be omitted, integrated, or distributed as desired and as required to suit a particular application.

In operation, many of the components of the building management system 20 employ a wide variety of interfaces for communication within the system. For example, in many instances of short distance communication NFC and Bluetooth may be employed. In others, for slightly larger distances Wi-Fi or wired communications are more typical. Further, as the distances between components expands, other serial communications, WAN, and Ethernet are more common. In many systems, to maintain compatibility and especially where the volume of data is relatively small, simple three wire serial communication structures such as RS-485, ACTnet, Bacnet are very commonly employed. However, with such interfaces, should the serial bus be improperly wired, then communication on the bus is hampered and diagnosing the fault can prove very time consuming and difficult. For the examples described here in serial communication between a controller 40 and environmental control hardware 42. For example a VAV controller, fan coil, and the like is addressed. In addition, the serial communication could be between a controller 40 and a sensor e.g. 36, 37, 38, 39.

Turning now to FIG 3 depicting a simplified communication timing structure for a communication network 18 employing a serial data bus shown generally as 60, and as may be employed for the various embodiments herein. In an embodiment, the communication network 18 employing communication bus 60 having a conventional three wire bus structure, where a first wire 62 provides power, a second wire 64 provides the ground reference, and a third wire 66 carries the data signal typically, though not necessarily, referenced to the ground on wire 64. In such a configuration the communication is half duplex. That is, bi-directional, one direction at a time. With such a serial data bus 60 configuration, detection of selected faults are determinable. For example if the power on wire 62 is an open circuit, the actuator 42 is unpowered, it can be noted as unresponsive and a fault may be indicated. Likewise, if the power on wire 62 is short circuited to ground, then the power supply in the controller 40 will detect an over current condition and identify the fault. Moreover, if the ground wire 64 is similarly faulted once again the actuator 42 will be unpowered and the fault detected and indicated. Finally, for the instances that the data wire 66 is open circuited or shorted to either the power on line 62 or ground on line 64 the test methodology of the described embodiments facilitates detection.

Continuing now with FIG. 3 and the expanded portion depicting the signal timing on the data wire 66. In an embodiment, the controller 40 sends a selected type (data bit) and amount of data to a recipient over the serial data bus 60. For example, the controller 40 may write a single known test byte. The controller 40 then reads the serial data bus 60 within a selected duration of having written the test data. In an embodiment, the selected duration may be based on the type of serial data bus 60 and the rate of data transmission. For example for a conventional 2400 baud communication protocol, the data should be read within 8.33 milliseconds. For higher data rates the duration within which the data is to be read, is commensurately shorter. In an embodiment, the read data word is then compared to the transmitted data word. If the read data does not match that which was transmitted, then a fault is determined. Selection of the type and/or size of the data word written by the controller 40 to the serial data bus 60 facilitates distinction of the potential faults and ascertaining status. For example, writing a "1" and reading a "0" would indicate a fault of a short to ground on the data wire 66. Likewise, writing a "0" and reading a "1" would indicate a fault of a short to the power supply on the data wire 66. Advantageously, if the data read matches the data that was written, no fault is identified and operation of the serial data bus 60 continues.

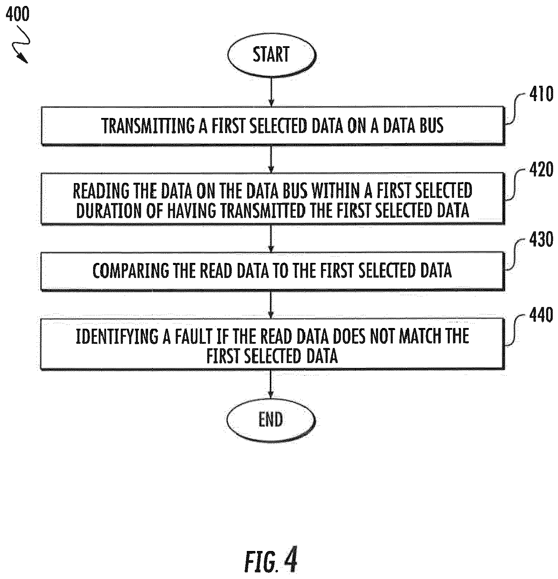

Turning now to FIG 4 depicting a flowchart of the method 400 of employing detecting a fault in a three wire half duplex communication data bus in accordance with an embodiment. The method 400 initiates with process step 410 where a selected data amount of data is transmitted on a data bus 60. At process step 420 the method 400 continues with reading the data bus 60 within a selected duration of having written the test data. For example, as described above, within 8.33 milliseconds. Turning now to process step 430, in an embodiment, the method 400 continues with comparing the read data from the data bus 60 to that which was transmitted. Finally, at process step 440, the method 400 includes identifying a fault condition in the data bus 60 if the read data does not match the transmitted data.

The present disclosure may be a system, a method, and/or a computer program product. The computer program product may include a computer readable storage medium (or media) having computer readable program instructions thereon for causing a processor to carry out aspects of the present invention. The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a hard disk, a random access memory (RAM), a read-only memory (ROM), a portable compact disc (CD), a digital versatile disk (DVD), a memory stick, and the like.

Computer readable program instructions described herein can be downloaded to respective computing/processing devices from a computer readable storage medium or to an external computer or external storage device via a network e.g., 18, for example, the Internet, a local area network, a wide area network and/or a wireless network. The network may comprise copper transmission cables, optical transmission fibers, wireless transmission, routers, firewalls, switches, gateway computers and/or edge servers, and the like.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

Benefits and advantages of the present disclosure include a method that automatically creates tailored, dynamic, energy efficient, building management system, HVAC and occupancy information and dynamic system color mapping of data based on selected tabular data. Advantageously this approach provides improved visualization for the user and an enhanced user experience. Other advantages include improved system performances and reduction in energy cost as better information about system performance is made available to a user.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

Further features of the disclosure, which may be combined with any of the previously discussed features, are given below in the following numbered embodiments:
Embodiment 1:
A building management system for controlling and monitoring systems in a building including an environmental control system, the building management system comprising:
environmental control hardware constructed and arranged to condition the environment; and
a serial data bus;
a controller, the controller operably connected to the serial data bus and configured to execute a process comprising:
   transmitting a first selected data, on the data bus;
   reading data on the data bus within a first selected time duration of having transmitted the first selected data;
   comparing the read data with the first selected data transmitted; and
   identifying a fault in the data bus if the read data does not match the first selected data; and
   wherein the environmental control hardware includes a receiver, the receiver operably connected to the data bus and configured to receive data on the data bus transmitted by the controller.

## Claims

1. A method (400) of detecting a fault in a data bus (60), the method comprising:
transmitting a first selected data, on the data bus (410);
reading data on the data bus within a first selected time duration of having transmitted the first selected data (420);
comparing the read data with the first selected data transmitted (430); and
identifying a fault in the data bus if the read data does not match the first selected data (440).

2. The method (400) set forth in claim 1, wherein the data bus (60) is a three wire half duplex data bus, optionally wherein the data bus (60) is at least one of an ACTnet data bus, and an RS-485 data bus.

3. The method (400) set forth in claim 1 or 2, wherein the first selected data includes at least one of a "1", and a "0".

4. The method (400) set forth in claim 1, 2, or 3, wherein the first selected time duration is based on a data rate of the data bus (60), optionally wherein the first selected time duration is 8.33 milliseconds when the data rate of the data bus (60) is 2400 baud.

5. The method (400) set forth in any preceding claims, wherein the identifying a fault includes ascertaining that the data bus (60) is shorted to a supply power if the read data is a "1" and the first selected data is not a "1"; and/or
wherein the identifying a fault includes ascertaining that the data bus (60) is shorted to ground if the read data is a "0" and the first selected data is not a "0".

6. The method (400) set forth in any preceding claims, further including disabling the data bus (60) if a fault is identified.

7. The method (400) set forth in any preceding claims, wherein the data bus (60) provides communication between a controller (40) and a component (54, 56) of an environmental control system (22), optionally wherein the component (54, 56) of the environmental control system (22) includes at least one of a variable air flow valve, a damper, and a fan coil.

8. A system for detecting a failure of a serial data bus (60), the system comprising:
a serial data bus (60);
a controller (40), the controller (40) operably connected to the serial data bus (60) and configured to execute a process comprising:
transmitting a first selected data, on the data bus (410);
reading data on the data bus within a first selected time duration of having transmitted the first selected data (420);
comparing the read data with the first selected data transmitted (430); and
identifying a fault in the data bus if the read data does not match the first selected data (440); and
a receiver, the receiver operably connected to the data bus (60) and configured to receive data on the data bus (60) transmitted by the controller (40).

9. The system set forth in claim 8, wherein the data bus (60) is a three wire half duplex data bus, optionally wherein the data bus (60) is at least one of an ACTnet data bus, and an RS-485 data bus.

10. The system set forth in claim 8 or 9, wherein the first selected data includes at least one of a "1" and a "0".

11. The system set forth in claim 8, 9, or 10, wherein the first selected time duration is based on a data rate of the data bus (60), optionally wherein the first selected time duration is 8.33 milliseconds when the data rate of the data bus (60) is 2400 baud.

12. The system set forth in any of claims 8 to 11, wherein the identifying a fault includes ascertaining that the data bus (60) is shorted to a supply power if the read data is a "1" and the first selected data is not a "1"; and/or
wherein the identifying a fault includes ascertaining that the data bus (60) is shorted to ground if the read data is a "0" and the first selected data is not a "0".

13. The system set forth in any of claims 8 to 12, further including disabling the data bus (60) if a fault is identified.

14. The system set forth in any of claims 8 to 13, wherein the receiver comprises a component (54, 56) of an environmental control system (22), optionally wherein the component (54, 56) of the environmental control system (22) includes at least one of a variable air flow valve, a damper, and a fan coil.

15. The system set forth is any of claims 8 to 14, wherein the system is a building management system (20) for controlling and monitoring systems in a building including an environmental control system (22), the building management system comprising:
environmental control hardware (42) constructed and arranged to condition the environment; and
wherein the environmental control hardware includes a receiver, the receiver operably connected to the data bus and configured to receive data on the data bus transmitted by the controller.
